Europäisches Patentamt

(19) European Patent Office

Office européen des brevets

(11) Publication number : **0 225 923 B1**

# EUROPEAN PATENT SPECIFICATION

(12)

(45) Date of publication of patent specification :
**20.02.91 Bulletin 91/08**

(21) Application number : **86904000.6**

(22) Date of filing : **10.06.86**

(86) International application number :
**PCT/US86/01264**

(87) International publication number :
**WO 86/07494 18.12.86 Gazette 86/27**

(51) Int. Cl.⁵ : **H01L 31/14, H01L 31/10,
G02F 3/00, H03K 19/14**

(54) SEMICONDUCTOR DEVICE.

(30) Priority : **14.06.85 US 745398**

(43) Date of publication of application :
**24.06.87 Bulletin 87/26**

(45) Publication of the grant of the patent :
**20.02.91 Bulletin 91/08**

(84) Designated Contracting States :
**DE FR GB NL**

(56) References cited :
**EP-A- 0 094 974
EP-A- 0 116 651
US-A- 4 065 729
US-A- 4 316 156
US-A- 4 427 990
US-A- 4 506 151**

(73) Proprietor : **AMERICAN TELEPHONE AND
TELEGRAPH COMPANY
550 Madison Avenue
New York, NY 10022 (US)**

(72) Inventor : **SIMMONS, John, George
157 Inner Promenade St. Annes-On-Sea
Lancashire (GB)**
Inventor : **TAYLOR, Geoffrey, Walter
10 Lucarelli Drive,
Holmdel, New Jersey 07733-1988 (US)**

(74) Representative : **Watts, Christopher Malcolm
Kelway et al
AT&T (UK) LTD. AT&T Intellectual Property
Division 5 Mornington Road
Woodford Green Essex IG8 OTU (GB)**

## Description

### Technical Field

This invention relates generally to the field of semiconductor devices and particularly to such devices for switching optical and electrical signals in optical logic circuits.

### Background of the Invention

Switches are an important class of semiconductor devices. Many types of such devices have been devised which are capable of switching either electronic or optical signals. A single device capable of simultaneously switching both optical and electrical signals and useful in optical logic circuit would be desirable. This is achieved according to this invention.

A solid state device, termed a BICFET (which is an acronym for Bipolar Inversion Channel Field Effect Transistor) has recently been developed. See EP-A-85904564 belonging to the state of the art according to Article 54 (3). In one embodiment, this device comprises a metallic emitter contacting a wider bandgap region ; a narrower bandgap collector region ; and a channel contact. The latter is to an inversion layer which is formed at the interface between the wider bandgap region and the narrower bandgap region. Further embodiments enable the BICFET to function as either a photodetector or a light emitter. However, simultaneous switching of both types of signals has not been reported.

### Summary of the Invention

We have found that a device as set out in claim 1 is capable of switching both optical and electrical signals. The device has distinct electrical and optical states. In the first state, the device has a high electrical impedance and emits no light. In the second state, the device has a low impedance and strong optical emission occurs. Switching between two states may be obtained by either optical or electrical inputs. Optical logic functions may be performed.

### Brief Description of the Drawing

FIG. 1 represents a device according to this invention ;

FIG. 2-4 are energy band diagrams useful in explaining the operation of the embodiment depicted in FIG. 1 ;

FIG. 5 is a schematic representation of another embodiment of this invention ;

FIG. 6 shows exemplary current-voltage characteristic curves for a device according to this invention ;

FIG. 7 is a schematic representation of an optical switch according to this invention ;

FIG. 8 is a schematic representation of an optical repeater according to this invention ;

FIG. 9 is a schematic representation of an optical NAND gate ; and

FIG. 10 is a schematic representation of an optical NOR gate.

### Detailed Description

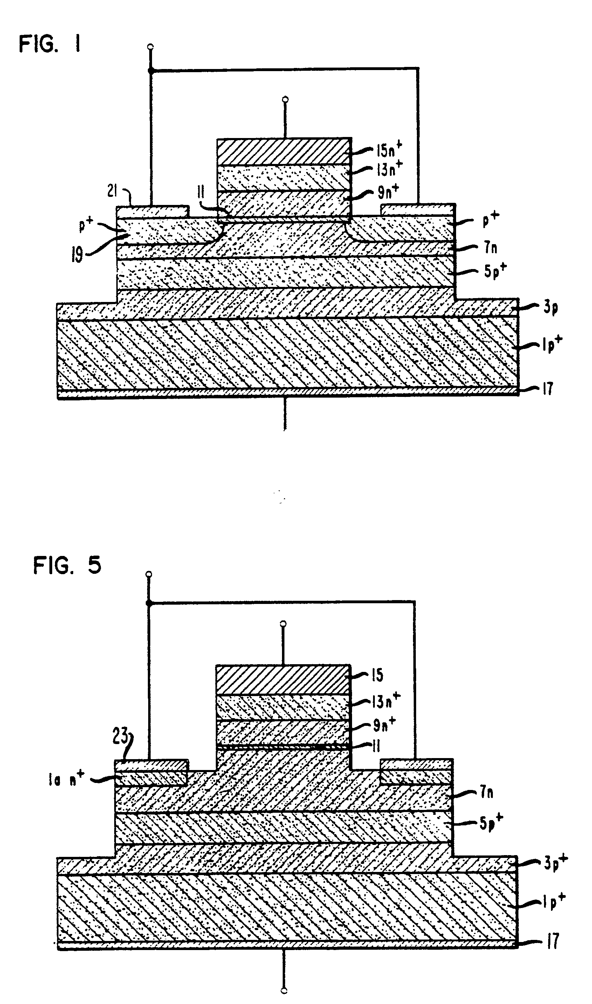

One embodiment of a device according to our invention is depicted in FIG. 1. The device comprises a substrate 1, buffer layer 3, wide bandgap layer 5, narrow bandgap layer 7, and a wide bandgap layer 9. Layer 7 is termed the collector. Layer 9 is fairly highly doped and is termed the semi-insulator. Near the interface between the collector 7 and the semi-insulator 9 there is a highly doped extremely thin layer 11. The highly doped layer 11, which is termed a charge sheet, may be in either layer 7 or 9, but in practice, it is often easier to place it in layer 7 to obtain the highest doping levels. A typical thickness is between 2 and 6 nm (20 and 60 Angstroms). The layer 11 is also termed the source. The top layer 13 is a heavily doped cap structure. The latter facilitates the formation of ohmic contacts. The highly doped cap layer 13, as well as a metallic layer 15, comprises the emitter contact. There is also an electrical contact 17 to the substrate and a contact 21 to the source 11 via a highly doped layer 19. In a preferred embodiment, the device is operated as an open source device, i.e., no voltage is applied to the source 11, and the device has but two terminals. Layers 3 and 5 have a first conductivity type and layers 7, 9 and 13 have a second conductivity type. The source 11 and the layer 19 also have the first conductivity type.

In a particular embodiment, the substrate 1 was highly doped p+ type GaAs, the buffer layer 3 was GaAs having a thickness of 0.3 $\mu$m and the wide bandgap layer 5 was a 0.5 $\mu$m thick layer of AlGaAs which was heavily doped p+. The narrow bandgap layer 7 comprised n-type GaAs and was 1. $\mu$m thick. The source 11 was 3 nm (30 Angstroms) thick and had an acceptor, (i.e., p type) doping level of approximately $10^{17}$cm$^{-3}$. The semi-insulator 9 was 40 nm (400 Angstrom) thick n-type AlGaAs. The cap layer 13 comprised heavily doped n+ GaAs having a thickness of 500 nm (5,000 Angstroms).

The epitaxial layers of the structure are expediently grown by known molecular beam epitaxy techniques. Other growth techniques are, however, possible.

After growth, the structure was masked and etched down to the p+ epitaxial buffer layer, thus forming a mesa structure. A further etching was performed to layer 7. A p+ diffusion was now made into layer 7 to form the source 11. Contacts to the cap layer, i.e., emitter, and source, if desired, were made using well-known and conventional lift-off techniques with Au/Sn. The collector metallization contacts at least part of the diffused region. If desired, there may be an open emitter area to allow for transmission of light through the cap layer. Conventional and well known lithographic techniques are used for the etching, diffusion and metallization steps. The contacts were alloyed in forming gas at 450 degrees C for approximately 20 seconds. A typical mesa diameter is 200 μm and the circular opening is typically 130 μm.

Other materials may be used. For example, other Group III-V compound semiconductors may be used as well as Group II-VI compound semiconductors. Furthermore, the dimensions given are exemplary only.

Several device operating characteristics are now summarized. The light versus current characteristics of the device were measured and it was found that almost no light was emitted for device currents less than approximately 3 ma. The emitter and wide bandgap regions were electrically contacted. However, when this current value was exceeded, the light output increased at first linearly, and finally saturated much as the light output does in a conventional light emitting diode. It is thus evident that essentially no light is produced in the electrical OFF state of the device and that the device functions as a light emitting diode in the ON state. The device is therefore characterized by two distinct optical states and may be switched electrically between the two.

However, the electrical switching characteristics of the device are strongly influenced by the intensity of any incident light. Total control over the switching voltage may be obtained with only a modest input optical intensity. This permits optical switching to be performed.

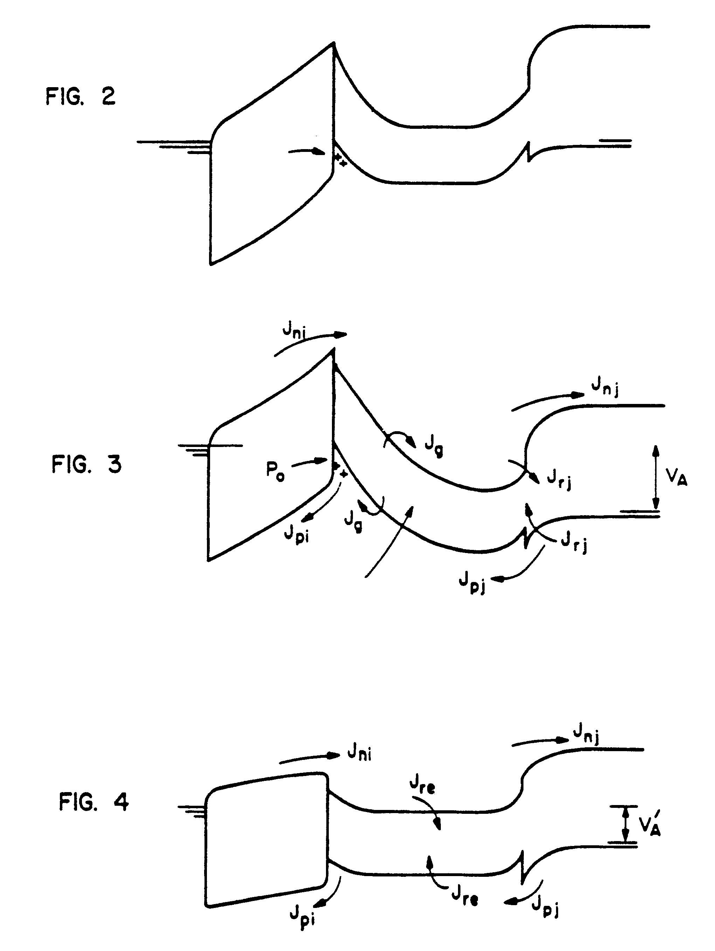

The device operation and switching may be better understood by reference to the energy band diagrams depicted in FIGS. 2-4. For reasons of clarity, only the semi-insulator, collector and wide bandgap layers, i.e., regions 5, 7 and 9, are depicted. The source 11, not shown, bends the collector region energy levels up at the interface, thus permitting formation of an inversion layer. FIGS. 2-4 show the zero bias case, a forward bias applied prior to switching and a forward bias applied after switching, respectively.

In the high impedance state before switching, the semi-insulator and the collector wide bandgap layer junction are slightly forward biased, but the collector depletion region is reverse biased and the voltage is dropped almost entirely in that region.

The various current components flowing are indicated as in FIG. 3. $J_{nI}$ and $J_{pI}$ are the electron and hole currents flowing in the semi-insulator ; $J_g$ is the generation current and the current in the collector depletion region ; $J_{rj}$ is the recombination current in the wide bandgap layer junction and $J_{nj}$ and $J_{pj}$ are the electron and hold diffusion currents, respectively, across the collector wide bandgap layer junction. Little voltage is dropped across the collector-wide bandgap layer and $J_{pj}$ and $J_g$ are small as is the hole current. $J_{nI}$ is small and the device is in a high impedance state. As the voltage is increased, $J_{pI}$ increases as does the bole concentration, $P_0$, at the semi-insulator collector interface.

The increase in $P_0$ occurs as a result of the production of electron hole pairs in the collector depletion region which may occur by, for example, light absorption as well as thermal generation. The increase leads to an increase in $J_{nI}$, and therefore in $J_{nj}$ and $J_{pj}$. When $J_{pj}$ is greater than $J_g$, there is a loop gain in excess of unity and the phases of the signals are such that the feedback is positive and the condition for instability exists. Regenerative switching occurs and the device enters the regime of negative resistance in which the voltage collapses and the current increases. When the voltage across the collector depletion region collapses to its minimum value, determined by the condition of strong inversion at the interface, the device leaves the region of negative resistance and the energy band diagram depicted in FIG. 4 results. The surface hole density has risen to a maximum value and both the semi-insulator and the collector wide bandgap junction are strongly forward biased.

The stable state is reached when the current gain internal to the device falls below unity. In the ON state, the recombination current effectively diverts the hole current flowing to the semi-insulator and the electron current flowing to the wide bandgap junction and consequently, the loop current gain of the system is reduced.

The substantial recombination occurring gives rise to strong electroluminescence as one would expect for a double heterostructure. With formation of a suitable optical cavity lasing action is obtained. Methods for example cleaving, for forming the cavity are well known and need not be described in detail.

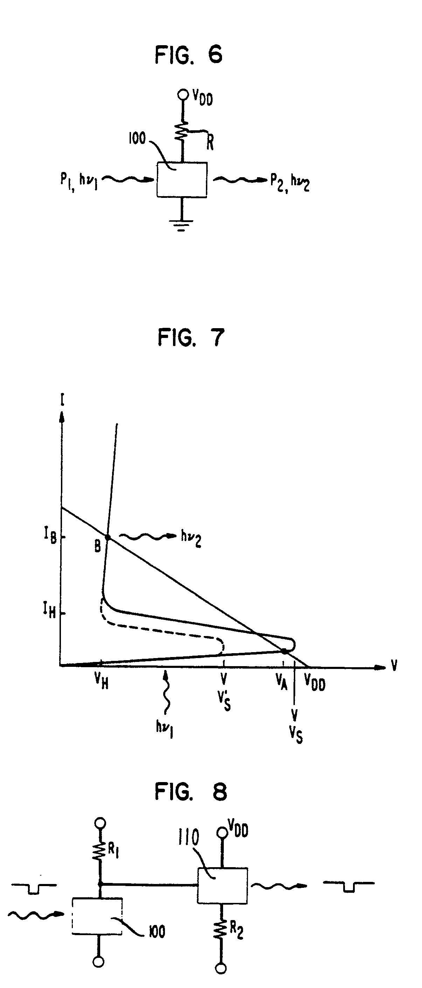

Other embodiments are possible. For example, in FIG. 5, an embodiment is depicted in which the collector 7 is contacted through contact 23. Numerals identical to those in FIG. 1 represent identical elements. In this case, an n+ diffusion la is made. Also, only the emitter and wide bandgap substrate region may be contacted if two terminal operation is desired. For either device (FIGs. 1 and 5), three terminal operation, as described hereinafter, is possible using either the connection 21 (FIG. 1) to the source 11 or the connection 23 (FIG. 5) to the collector 7.

Both devices depicted may have light enter through the emitter contact and be emitted through the emitter contact. However, the light may be incident parallel to the collector layer, i.e., directly into the cavity. This is a preferred embodiment for lasing action as the optical cavity, as well as optical confinement, are more easily obtained. Of course, light will be emitted parallel to the longitudinal axis of the cavity.

One device application is indicated schematically in FIG. 6. In addition to the double heterostructure opto-electronic switch just described and indicated generally as 100, there is a resistance R, placed in series between switch 100 and a voltage source, $V_{DD}$. The other switch connection is made to ground. Thus, the emitter is connected to ground and the wide bandgap region 5 is connected, via the device substrate 1, to the voltage source.

The operation of the device is best explained by reference to FIG. 7 which is an exemplary current-voltage characteristic curve. In the OFF state, the load resistor and the OFF state of the characteristic intersect at point A. For maximum sensitivity, the quiescent voltage $V_A$, is selected to be as close as possible to $V_S$. Thus, when a small light signal $hV_1$, with $V_1$ being greater than the bandgap, is incident on the device active area, the switching voltage decreases from $V_s$ to $V'_s$. The illuminated characteristic is shown by the dashed line. The only stable operating point is at B for this condition. This is the point at which the load resistor cuts the ON state of the device. In the ON state, the device emits light at a frequency $V_2$ which is characteristic of the bandgap of the collector that is, the active region, and of well-defined optical power proportional to a well-defined current. Therefore, the device accomplishes the function of optical regeneration as shown in FIG. 6. That is, an optical signal at a power $P_2$ and frequency $V_2$ is produced by an optical signal having a power $P_1$ and frequency $V_1$. $P_2$ can be equal to or greater than $P_1$.

The switch may be turned OFF by lowering the voltage below $V_H$, the holding voltage for the ON state, while reducing the current through the switch below the holding current in the ON state.

With the use of a smaller series resistor the current in the ON state and hence, the intensity of the light emitter can be varied. In other words the optical gain is limited only by the power dissipation handling capabilities of the switch. The slope of the line between A and B is proportional to (1/R), and appropriate choice of R will thus determine the output light intensity.

Another application is indicated schematically in FIG. 8. This application represents a digital optical receiver using two switches 100 and 110. The first switch 100 is a two terminal device connected as in FIG. 6, and the second switch 110 is a three terminal device as in FIG. 1 or FIG. 5 and having a resistance $R_2$ between the emitter and ground. The two switches are electrically connected between the substrate of the first switch and the third terminal of the second switch. The first switch receives the incident light and is biased with resistor $R_1$. The choice of $R_1$ is evident from the discussion of FIG. 7. When no light is incident the device is stable in the OFF state at point A. With an optical 1 signal that is, incident light the IV characteristic changes as shown in FIG. 7 and the device is stable in the ON state at point B. When the optical intensity drops, the IV curve reverts to the dark illumination situation and the device returns to point A. The optical output of the first switch is not being used. The device is biased at a very low power level in the ON state. It is a switch used as a high speed optical to electrical transducer. During operation, the collector voltage of the first switch moves between $V_{DD}$ and $V_H$. Thus, the optical signal is converted to a digital electrical form. The signal at this point is large, essentially $V_{DD}$-$V_H$, and has been obtained due to the large optical to electrical gain inherent in the device. A regenerated optical signal used as an input into another optical fiber may be obtained by using the electrical signal from the first switch to drive the electrical input terminal of the second switch as shown, i.e., the first and second switches are connected between the substrate and third terminal respectively. The second switch turns ON and the light output intensity is determined almost entirely by the load resistor $R_2$. The role played by the second switch is that of combined laser and laser driver.

An inverter can easily be obtained by a modification of FIG. 8. The first and second switches as well as resistances $R_1$ and $R_2$ are interchanged and light is incident from the right rather than the left.

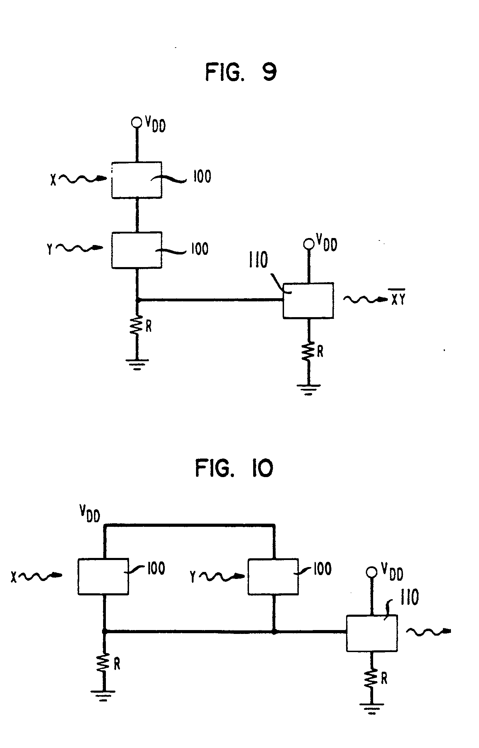

Other optical logic circuits are possible. An optical NAND circuit is depicted in FIG. 9. It comprises first and second series connected switches 100. The emitter contact of the second switch is connected to resistance R and the third terminal of a third switch 110 of the type shown in FIG. 1 or FIG. 5. The emitter contact of the third switch is connected to ground through resistance R. The substrates of the first and third switches are connected to $V_{DD}$. The operation of this circuit is evedent to those skilled in the art and is not described.

An optical NOR gate is depicted in FIG. 10. This is similar to FIG. 9, except that the first and second switches are parallel, rather than series connected between $V_{DD}$ and resistance R. Again, operation of the circuit is evident to those skilled in the art and is not described.

## Claims

1. A semiconductor optoelectronic switch responsive to electrical and optical signals and capable of emitting light in its low impedance state, comprising first (9, 11 ; 9) and second (7 ; 7, 11) regions having a first conductivity type and having a first interface therebetween adapted to the formation of an inversion layer, the bandgap of said second region being less than that of said first region, a first electrical contact (15) to said first region, a third region (5) having a second conductivity type and a bandgap greater than that of said second region, said second and third regions having a second interface, a second electrical contact (17) to said third region, and means arranged to optically illuminate said second region.

2. A device as in claim 1 including a third electrical contact (21 or 23) to said inversion layer or said second (7 ; 7, 11) region.

3. A device as recited in claim 1 including a resistance (R) connected to said third region (5).

4. A device as recited in claim 1 including a resistance (R) connected to said first (9 ; 9, 1) region.

5. An optical regenerator circuit comprising a first device (110) according to claim 2 and a second device (100) according to claim 3, the third electrical contact of said first device (110) being electrically connected to the third region (5) of said second device, the optical signal being incident on said second device (Fig. 8).

6. An optical NAND circuit comprising a series connected first device (100) according to claim 1 and a second device (100) according to claim 4, and a third device (110) according to claim 2, the third terminal of said third device being connected to the first region (9 ; 9, 11) of said second device (Fig. 9).

7. An optical NOR circuit comprising a first device (100) according to claim 4 and a second device (100) according to claim 1 connected in parallel, and a third device (110) according to claim 2, the third terminal of said third device being connected to the first regions (9 ; 9, 11) of the first and second device (Fig. 10).

## Ansprüche

1. Optoelektronischer Halbleiterschalter, der auf elektrische und optische Signale anspricht und im Zustand niedriger Impedanz Licht emittieren kann, mit einer ersten (9, 11 ; 9) und einer zweiten (7 ; 7, 11) Zone eines ersten Leitfähigkeitstyps und einer ersten Grenzfläche zwischen sich, die zur Bildung einer Inversionsschicht geeignet ist, wobei die Bandlücke der zweiten Zone kleiner als die der ersten Zone ist, mit einem ersten elektrischen Kontakt (15) zu der ersten Zone, mit einer dritten Zone (5) eines zweiten Leitfähigkeitstyps und mit einer Bandlücke größer als die der zweiten Zone, wobei die zweite und die dritte Zone eine zweite Grenzfläche besitzen, mit einem zweiten elektrischen Kontakt (17) zu der dritten Zone und mit einer Einrichtung zur optischen Bestrahlung der zweiten Zone.

2. Halbleiterschalter nach Anspruch 1 mit einem dritten elektrischen Kontakt (21 oder 23) zu der Inversionsschicht oder der zweiten Zone (7 ; 7, 11).

3. Halbleiterschalter nach Anspruch 1 mit einem Widerstand (R), der mit der dritten Zone (5) verbunden ist.

4. Halbleiterschalter nach Anspruch 1 mit einem Widerstand (R), der mit der ersten Zone (9 ; 9, 11) verbunden ist.

5. Optische Regeneratorschaltung mit einem ersten Halbleiterschalter (110) nach Anspruch 2 und einem zweiten Halbleiterschalter (100) nach Anspruch 3, bei der der dritte elektrische Kontakt des ersten Halbleiterschalters (110) elektrisch mit der dritten Zone (5) des zweiten Halbleiterschalters verbunden ist und bei der das optische Signal auf den zweiten Halbleiterschalter auffällt (Fig. 8).

6. Optische NAND-Schaltung mit einer Reihenschaltung eines ersten Halbleiterschalters (100) nach Anspruch 1 und eines zweiten Halbleiterschalters (100) nach Anspruch 4 sowie eines dritten Halbleiterschalters (110) nach Anspruch 2, wobei der dritte Anschluß des dritten Halbleiterschalters mit der ersten Zone (9 ; 9, 11) des zweiten Halbleiterschalters verbunden ist (Fig. 9).

7. Optische NOR-Schaltung mit einem ersten Halbleiterschalter (100) nach Anspruch 4 und einem zweiten, parallelgeschalteten Halbleiterschalter (100) nach Anspruch 1 sowie einem dritten Halbleiterschalter (110) nach Anspruch 2, wobei der dritte Anschluß des dritten Halbleiterschalters mit der ersten Zone (9 ; 9, 11) des ersten und des zweiten Halbleiterschalters verbunden ist (Fig. 10).

## Revendications

1. Un élément de commutation opto-électronique à semiconducteurs qui réagit à des signaux électriques et optiques et qui est capable d'émettre de la lumière dans son état à basse impédance, comprenant des première (9, 11 ; 9) et seconde (7 ; 7, 11) régions ayant un premier type de conductivité et ayant une première interface entre elles qui est prévue pour la formation d'une couche d'inversion, la bande interdite de la seconde région étant inférieure à celle de la première région, un premier contact électrique (15) avec la première région, une troisième région (5) ayant un second type de conductivité et une bande interdite supérieure à celle de la seconde région, les seconde et troisième régions ayant une seconde interface, un second contact électrique (17) avec la troisième région, et des moyens conçus pour illuminer optiquement la seconde région.

2. Un dispositif selon la revendication 1, comprenant un troisième contact électrique (21 ou 23) avec la couche d'inversion ou la seconde région (7 ; 7, 11).

3. Un dispositif selon la revendication 1, comprenant une résistance (R) connectée à la troisième région (5).

4. Un dispositif selon la revendication 1, comprenant une résistance (R) connectée à la première région (9 ; 9, 11).

5. Un circuit régénérateur optique comprenant un premier dispositif (110) conforme à la revendication 2, et un second dispositif (100) conforme à la revendication 3, le troisième contact électrique du premier dispositif (110) étant connecté électriquement à la troisième région (5) du second dispositif, et le signal optique tombant sur le second dispositif (figure 8).

6. Un circuit NON-ET optique comprenant un premier dispositif (100) conforme à la revendication 1 et un second dispositif (110) conforme à la revendication 4, connectés en série, et un troisième dispositif (110) conforme à la revendication 2, la troisième borne de ce troisième dispositif étant connectée à la première région (9 ; 9, 11) du second dispositif (figure 9).

7. Un circuit NON-OU optique comprenant un premier dispositif (100) conforme à la revendication 4 et un second dispositif (100) conforme à la revendication 1, connectés en parallèle, et un troisième dispositif (110) conforme à la revendication 2, la troisième borne du troisième dispositif étant connectée aux premières régions (9 ; 9, 11) des premier et second dispositifs (figure 10).

FIG. 1

FIG. 5

7

FIG. 2

FIG. 3

FIG. 4

## FIG. 6

## FIG. 7

## FIG. 8

FIG. 9

FIG. IO